# EUROPEAN PATENT SPECIFICATION

(11) **EP 2 333 968 B1**
(45) Date of publication and mention of the grant of the patent: **08.02.2012**
(21) Application number: 09290923.3
(22) Date of filing: 09.12.2009
(51) Int. Cl.: H04B 1/00, H04B 1/04, H03F 1/32

(54) **Transmitter arrangement for fragmented spectrum RF signals**
Sendeanordnung für ein aufgespaltetes RF Spektrum Signal
Dispositif transmetteur pour un spectrum fragmentées d'un signal RF

(43) Date of publication of application: 15.06.2011
(73) Proprietor: Alcatel Lucent, 75008 Paris (FR)
(72) Inventor: Wiegner, Dirk, 71409 Schwaikheim (DE); Jüschke, Patrick, 75428 Illingen (DE); Machinal, Robin, 70197 Stuttgart (DE)
(74) Representative: Schmidt, Werner Karl

(56) References cited:
- EP-A1- 1 993 210
- EP-A2- 1 793 504
- WO-A1-2008/154077

## Description

### Field of the Invention

The invention relates to the field of telecommunications, and, more particularly, to amplification of RF signals spread over a wide frequency range.

### Background

This section introduces aspects that may be helpful in facilitating a better understanding of the invention. Accordingly, the statements of this section are to be read in this light and are not to be understood as admissions about what is in the prior art or what is not in the prior art.

Usually, transmitters for radio systems support only one frequency band and one mobile radio standard. For parallel transmission of a plurality of frequency bands distributed over a wide frequency range (so-called fragmented spectrum signals), typically a full transmitter line-up has to be provided for each addressed frequency band. However, such an approach clearly shows only low energy efficiency and an increased number of required hardware components. Moreover, when using feedback about the amplified fragmented spectrum RF signal in order to perform linearization of the amplification, a feedback path used for providing the feedback typically acts as a kind of a bottleneck with respect to bandwidth, affecting the linearization e.g. by limiting the linearizable signal bandwidth.

EP 1 993 210 A1 discloses a transmitter arrangement with the features of the preamble of claim 1.

### Summary

The present invention is directed to addressing the effects of one or more of the problems set forth above. The following presents a simplified summary of the invention in order to provide a basic understanding of some aspects of the invention. This summary is not an exhaustive overview of the invention. It is not intended to identify key or critical elements of the invention or to delineate the scope of the invention. Its sole purpose is to present some concepts in a simplified form as a prelude to the more detailed description that is discussed later.

One aspect relates to a transmitter arrangement for amplifying a fragmented spectrum RF signal having a plurality of frequency bands with different carrier frequencies, the transmitter (path) arrangement comprising: a plurality of frequency paths, each for generating a single-band RF signal with a different carrier frequency, a combiner for generating the fragmented spectrum RF signal by combining the plurality of single-band RF signals, and an amplifier unit adapted for amplification of the fragmented spectrum RF signal. The transmitter arrangement further comprises a feedback path adapted for temporally alternately generating feedback for the different frequency bands of the amplified fragmented spectrum RF signal.

For allowing for effective parallel amplification of a plurality of frequency bands, it is proposed to generate a plurality of single-band RF signals having different carrier frequencies, and to combine the RF signals to form a fragmented spectrum RF signal which can subsequently be amplified in a wideband amplifier. Since the combining is done before the amplification, i.e. on a low power level, the combining has only very low effect on the overall efficiency. From the output of the power amplifier, the fragmented spectrum RF signal is typically fed to a transmit antenna via a suitable antenna network.

The transmitter arrangement also has a feedback path, preferably for linearization of the amplification of the amplifier unit, the feedback path being adapted for temporally alternately generating feedback about the different frequency bands of the amplified fragmented spectrum RF signal. The feedback path typically provides an output signal of the amplifier to the (digital) signal processing unit. The digital signal processing unit uses the feedback signal for enabling adaptive linearization e.g. (digital) pre-distortion of the baseband signal, the pre-distortion being reciprocal to the distortion caused by the amplification, thus allowing for linearization of the amplification. One skilled in the art will appreciate that alternatively or in addition, the feedback may be used to perform an optimization of the signal processing which is not related to the linearity of the amplification.

In one embodiment, each frequency path comprises a mixer for generation of the single-band RF signal by mixing up (up-converting) a single-band baseband signal to the respective carrier frequency. Each of the mixers allows for shifting a single-band baseband signal to an individual carrier frequency, the carrier frequencies being typically chosen in accordance with the carrier frequencies of specific radio transmission standards (typically in the GHz range). The single-band baseband signals as well as the mixed-up RF signals have the same signal bandwidth, being typically in the order of several tens of MHz. One skilled in the art will appreciate that the local oscillator frequency of the mixers and thus the signal carrier frequencies can be selected/adapted within the bandwidth capabilities of e.g. the power amplifier, thus allowing to address a plurality of different frequency bands.

In one improvement, each frequency path comprises a filter for generating the single-band baseband signal by filtering a fragmented spectrum baseband input signal having a plurality of frequency bands with different center frequencies. For effectively generating the single-band baseband signals which are provided to the mixers, it is proposed to generate a single fragmented spectrum baseband signal and to provide only the frequency band which is to be mixed up at the output of the filter.

In this respect, it should be noted that using different frequency paths with a plurality of mixers allows for individual adjustment of the carrier frequencies and thus of the spacing of the RF frequency bands, in particular when wide-band mixers are used. This creates an additional freedom when generating the fragmented spectrum signal, as the spacing between the individual baseband frequency bands may be chosen in relation to the filter quality (selectivity), i.e. using large spacing between the baseband frequency bands allows for using less effective filters. However, although limiting the freedom of choice for generating the fragmented spectrum signal, narrow-band mixers may be used as well, as the latter may increase the transmitter performance, e.g. with respect to noise.

The fragmented spectrum baseband signal may be generated in a digital signal processing unit which is typically arranged in a baseband part of a base station. The digital signal processing unit allows for generation of a digital baseband signal which is analog-to-digital converted before being provided to a power splitter for distributing the fragmented spectrum baseband signal as an analog signal to the different signal paths. As the splitting is done at a very low power level, the splitting has only a very small impact on overall efficiency.

In one embodiment, the feedback path comprises a plurality of frequency paths for the different frequency bands of the fragmented spectrum RF signal, the feedback path further comprising at least one switch for switching between the frequency paths. For instance, one switch may be provided at the start and a further switch may be provided at the end of the parallel frequency paths for selectively connecting one frequency path to both the amplifier output and the digital signal processing unit. Thus, the spectra of the two frequency bands (including the related inter-modulation distortions (IMDs) which are necessary for linearization) may be provided temporally alternately to the digital signal processing unit, e.g. for performing linearization based on each currently available frequency band. As efficient linearization does not necessarily require an immediate adjustment of the pre-distortion of each frequency band, it may be sufficient for the linearization to alternately consider two or more frequency bands for overall power amplifier linearization.

Each frequency path of the feedback path may additionally comprise an intermediate frequency amplifier for amplification of a feedback signal which is related to one frequency band. Intermediate frequency (If) amplification may be performed for allowing an easier processing of the feedback signal in the digital signal processing unit.

For achieving successful linearization and thus high efficiency, the feedback path bandwidth should be up to approx. four times the signal bandwidth. Since the bandwidth of currently used feedback paths is typically about 100 - 120 MHz, the supported signal bandwidth is limited to around 30 MHz and linearization of signals with fragmented frequency bands which are distributed e.g. over a frequency range of some 100 MHz cannot be supported. However, when performing switched feedback of only one frequency band in the way described above, the currently used bandwidth of the feedback path of about 100 to 120 MHz is sufficient for performing linearization over the entire (wideband) bandwidth range of the fragmented spectrum RF signal.

In one improvement, each of the frequency paths of the feedback path comprises a filter for generating a feedback signal related to one of the frequency bands of the fragmented spectrum RF signal. The filter is typically implemented as a band-pass filter which is adapted for passing only the selected frequency band of the feedback signal to the filter output.

In one development, a mixer is provided in the feedback path for down-conversion of the fragmented spectrum RF signal, preferably to an intermediate frequency. The mixer may be provided in the feedback path before a switch which divides the feedback path into the different frequency paths. Thus, the feedback signal which is provided to the frequency paths is an intermediate frequency (If) signal, allowing simplified signal processing in the individual frequency paths. Alternatively, a splitter may be used for providing the amplified fragmented spectrum RF signal as an input to two parallel (single-band) mixers, each mixer being arranged in a different frequency path and having a local oscillator frequency which is chosen in dependence of the carrier frequency of the addressed frequency band. A switch may be used for switching between the parallel-frequency paths for providing the currently addressed down-converted signal from one of the mixers to a filter and subsequently to an If amplifier.

In a further development, the mixer is adapted for switching its local oscillator frequency in dependence of the frequency band of the amplified fragmented spectrum RF signal for which the feedback is to be generated. By temporally alternating the local oscillator frequency of the (wideband) mixer based on the fragmented frequency band to be currently supported, the same feedback hardware can be used in a time-shared manner, such that the use of parallel frequency paths can be dispensed with.

It will be understood that the equipment arranged in the feedback path is not limited to the devices described above and may be subject to modification. For example, instead of using conversion to an intermediate frequency, direct down-conversion to the baseband frequency range may be performed. Also, instead of using two If amplifiers, it may be possible to use a single (broadband) If amplifier for both frequency ranges. Also, only a single filter, possibly having an adjustable filter characteristic, may be deployed in the feedback path.

Further aspects relate to a base station and to a radio network comprising at least one transmitter arrangement as described above, thus allowing to address fragmented frequency bands and different communication standards with the same hardware.

Another aspect relates to a method for fragmented signal amplification, comprising: generating a plurality of single-band RF signals at different carrier frequencies, generating a fragmented spectrum RF signal by combining the plurality of single-band RF signals, and amplifying the fragmented spectrum RF signal using broadband amplification, the method further comprising: performing linearization of the amplification of the fragmented spectrum RF signal by alternately using feedback for the different frequency bands of the fragmented spectrum RF signal. The method allows for efficient parallel amplification of a plurality of frequency bands being distributed over a wide frequency range (e.g. in the order of >100 MHz). Moreover, by providing feedback to a digital signal processing unit by switching between the different frequency bands, the linearization may be performed based on each currently available frequency band. Thus, the linearization can alternately consider two or more frequency bands for overall linearization of the power amplifier.

In one variant, the step of generating the single-band RF signals comprises mixing up (up-converting) single-band baseband signals to the respective carrier frequency, the single-band baseband signals being preferably generated by filtering a fragmented spectrum baseband signal having a plurality of frequency bands with different center frequencies. As the filtering is performed at a low power level, the filtering has only a small impact on overall efficiency.

Using the above approach, several frequency bands (the number of frequency paths depending on the number of used frequency bands) of e.g. up to 100 - 120 MHz, distributed over a wide frequency range (e.g. 1.8 GHz up to 2.7 GHz), and thus fragmented frequency band applications such as Software Defined Radio or Cognitive Radio may be supported.

Further features and advantages are stated in the following description of exemplary embodiments, with reference to the figures of the drawing, which shows significant details, and are defined by the claims. The individual features can be implemented individually by themselves, or several of them can be implemented in any desired combination.

### Brief Description of the Figures

Exemplary embodiments are shown in the diagrammatic drawing and are explained in the description below. The following are shown:
- **Fig. 1**: shows a schematic diagram of a transmit path of an embodiment of a transmitter arrangement according to the invention,
- **Fig. 2**: shows a schematic diagram of a feedback path for the transmitter arrangement of Fig. 1 with two parallel frequency paths and a wideband mixer,
- **Fig. 3**: shows a schematic diagram of a feedback path having two parallel frequency paths, each with a single-band mixer, and
- **Fig. 4**: shows a schematic diagram of a feedback path with a wideband mixer and local oscillator frequency switching.

### Description of the Embodiments

The functions of the various elements shown in the Figures, including any functional blocks labeled as 'processors', may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'processor' or 'controller' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

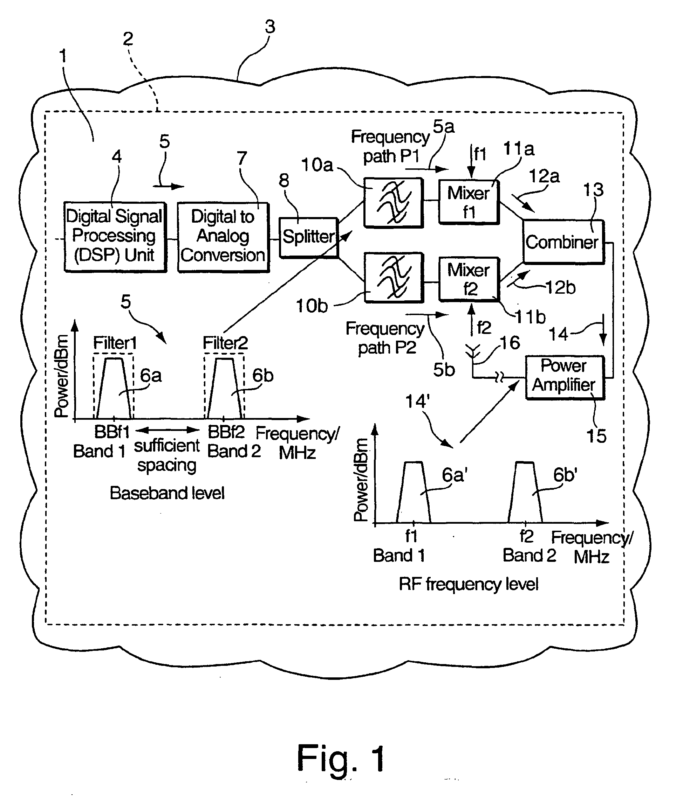

**Fig. 1** shows an transmitting path arrangement **1** of a base station **2** of a radio network **3** which operates in accordance with one or more radio transmission standards. The transmitter arrangement 1 comprises a digital signal processing unit **4**, being arranged in a baseband part (not shown) of the base station 2.

The digital signal processing unit 4 is adapted for generating and for conditioning (e.g. linearization, imbalance compensation, signal dynamic reduction, etc.) of a baseband signal **5.** In the present case, the digital signal processing unit 4 generates a baseband signal having two baseband frequency bands **6a, 6b** with different baseband center frequencies **BBf1, BBf2** (also referred to as a fragmented spectrum signal). The center frequencies BBf1, BBf2 are sufficiently spaced apart for allowing efficient separation of the frequency bands 6a, 6b by filtering later in the transmitter line-up. The choice of the center frequencies BBf1, BBf2 depends on the characteristics of the transmitter arrangement 1, the bandwidth of each frequency band 6a, 6b being, in the order of e.g. about 20 MHz in the present example.

The digital baseband signal 5 generated by the digital signal processing unit 4 is then fed to a digital-to-analog converter **7.** From there, the analog baseband signal 5 is fed to a splitter **8** for splitting the baseband signal 5 into two identical signals by power splitting. At the two outputs of the splitter 8, two identical copies of the baseband signal 5 (with reduced power) are produced and are subsequently provided to two parallel frequency paths **P1, P2.**

The copy of the baseband signal 5 which is provided to the first frequency path P1 is then fed to a first filter **10a** for generating a single-band baseband signal 5a located about the baseband frequency BBf1 of the first frequency band 6a. In a similar way, the copy of the baseband signal 5 provided to the second frequency path P2 is provided to a second filter **10b** for generating a single-band baseband signal 5b being located about the baseband frequency BBf2 of the second frequency band 6b.

The first and second single-band baseband signals 5a, 5b comprising the first and second frequency band 6a, 6b are then provided to a respective mixer **11a, 11b** arranged in the first, resp., in the second frequency path P1, P2. By the respective mixer 11 a, 11 b the two single-band baseband signals 5a, 5b are mixed up (shifted) to a first RF carrier frequency **f1** (in case of the first baseband frequency BBf1) and to a second RF carrier frequency **f2** (in case of the second baseband frequency BBf2). After this up-conversion, the two single-band RF signals **12a, 12b** thus produced are combined by a suitable combiner **13** to produce a single RF signal **14** (being referred to as a fragmented spectrum signal in the following), comprising both the first and the second single-band RF signal 12a, 12b.

The fragmented spectrum RF signal 14 is then fed from the combiner 13 to an input of a power amplifier 15, which has to support the full RF frequency range covered by the fragmented spectrum RF signal 14. By the direct up-conversion using the two frequency paths P1, P2, the RF carrier frequencies f1, f2 can be selected independently from each other and can be changed e.g. depending on the capabilities of the mixer 11a, 11 b and of the power amplifier 15. The amplified fragmented spectrum RF signal 14' comprising two frequency bands 6a', 6b' with different RF carrier frequencies is then provided to a transmit antenna **16** over a suitable antenna network (not shown).

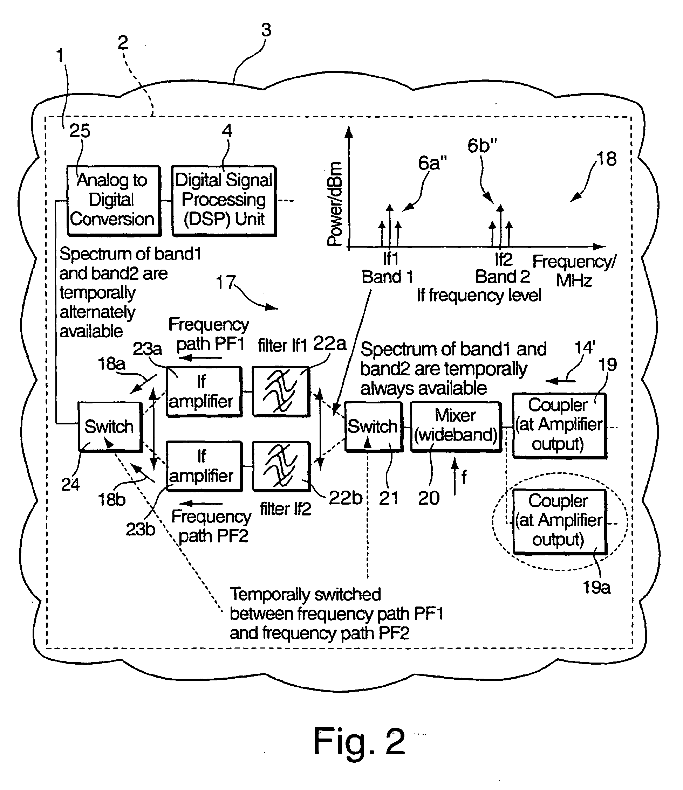

In the following, a first variant of a feedback path **17** for providing either a first or a second frequency band 6a", 6b" of a feedback signal **18** to the digital signal processing unit 4 will be described with reference to **Fig. 2****.** The feedback signal 18 (at the Intermediate frequency level) is derived from the amplified RF signal 14' at the output of the power amplifier 15 in a way described further below. The feedback signal 18 is used in the digital signal processing unit 4 e.g. for linearization of the amplification of the power amplifier 15 by performing (digital) pre-distortion of the fragmented-spectrum baseband signal 5.

In the feedback path 17, the output spectrum of the power amplifier 15 is sensed by a coupler **19,** which feeds the amplified RF signal 14' to a broadband mixer **20** adapted for performing down-conversion of the entire signal spectrum to (in this example) an intermediate frequency (If) level. The feedback signal 18 at the output of the mixer 20 having the power spectrum shown in Fig. 2 is then fed to a first switch **21** which temporally alternately provides the feedback signal 18 to a first and to a second parallel frequency path **PF1, PF2** of the feedback path 17.

The first frequency path PF1 comprises a filter **22a** which allows to pass only the first frequency band 6a located about a first (intermediate) center frequency If1. The second frequency path PF2 also comprises a filter **22b** allowing to pass only the second frequency band 6b located at a second (intermediate) frequency If2. The intermediate frequencies If1, If2 correspond to the carrier frequencies f1, f2, being shifted by an amount which is defined by the local oscillator / mixing frequency f.

The filter bandwidth of the respective filters 22a, 22b is chosen sufficiently broad such that inter-modulation distortions (IMDs) which slightly deviate from the center frequencies If1, If2 (see the (small) arrows in the power spectrum of Fig. 2) are also covered, the IMDs being useful for performing the linearization. As described above, at the output of the first filter 22a, only the first frequency band 6a" is available, and at the output of the second filter 22b, only the second frequency band 6b" is available and is amplified in a respective intermediate frequency amplifier **23a, 23b.** The two If amplifiers 23a, 23b are followed by a second switch **24** which temporally alternately provides a feedback signal 18a related to the first frequency band 6a" and a feedback signal 18b related to the second frequency band 6b" to a single output of the second switch 24.

At the output of the second switch 24, the feedback signals 18a, 18b of the first frequency path PF1 and of the second frequency path PF2 are thus temporally alternately available and are fed to an analog-to-digital converter **25.** The total bandwidth of the temporally available feedback signal 18a, 18b is e.g. about 100-120 MHz and can thus be easily converted by the A/D-converter 25. After the converter 25, the digital temporally alternately available feedback signals 18a, 18b related to the first and second frequency band 6a", 6b", respectively, (each including intermodulation distortions) are provided to the digital processing unit 4 for performing the linearization by digital pre-distortion or for taking other measures which are suitable for improving the overall amplification quality.

In the way described above, the linearization may consider both frequency bands 6a", 6b" and thus a wider bandwidth for the overall amplifier linearization, which supports fragmented frequency band applications or increased overall signal bandwidth applications. By adding a second coupler **19a,** it may also be possible to apply a similar procedure for supporting linearization of two amplifiers of the base station 2 by using a single, common feedback path. It will be understood that in order to support such a feedback architecture and its rotate applications, the linearization will have to be adapted, for instance concerning the temporally provided frequency bands and the required signal processing.

When keeping the local oscillator frequency f of the wideband mixer 20 constant, frequency band-related input signals will be fed to the analog-to-digital converter 25, which - depending on the width of the frequency range spanned by the fragmented spectrum RF signal 14 - may cause the input signals to be outside of the input range of the analog-to-digital converter 25.

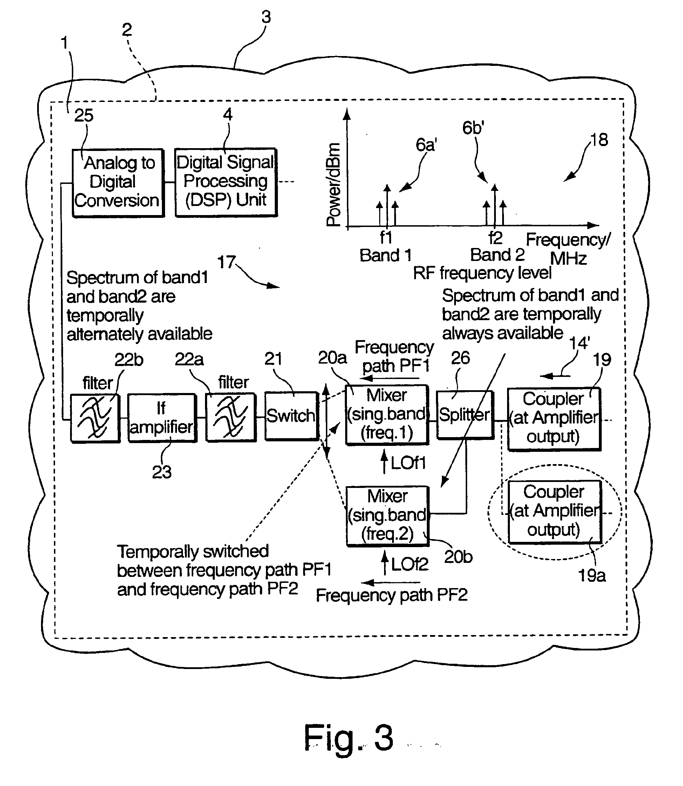

For addressing this problem, **Fig. 3** shows a feedback path 17 which differs from the one shown in Fig. 2 in that instead of the broadband mixer 20, two single-band mixers **20a, 20b** are provided, one for each addressed frequency band 6a', 6a' at the RF frequency level, each of the single-band mixers 20a, 20b having its own local oscillator frequency LOf1, LOf2. By using two different local oscillator frequencies LOf1, LOf2 which are chosen in dependence of the carrier frequencies f1, f2 of the amplified RF signal 14', it can be assured that the input to the analog-to-digital converter 25 is always in the desired input range.

In order to use the feedback path 17 temporally for the different spectra of the frequency bands 6a', 6b', a splitter 26 is arranged in front of the mixers 20a, 20b. The splitter 26 is used for feeding the amplified RF signal 14' to two different frequency paths PF1, PF2 in which the mixers 20a, 20b are arranged. A switch 21 which is arranged after the mixers 20a, 20b is used to feed the currently addressed down-converted signal to a filter 22a and subsequently to an If amplifier 23 and from there - via a further filter 22b - to the analog-to-digital converter 25. One skilled in the art will appreciate that instead of the two filters 22a, 22b, a single filter with sufficiently steep filter characteristics may be used. In either case, using the switch 21, the down-converted signals of either the first mixer 20a or the second mixer 20b can thus be fed to the filter 22a in a temporally alternate manner.

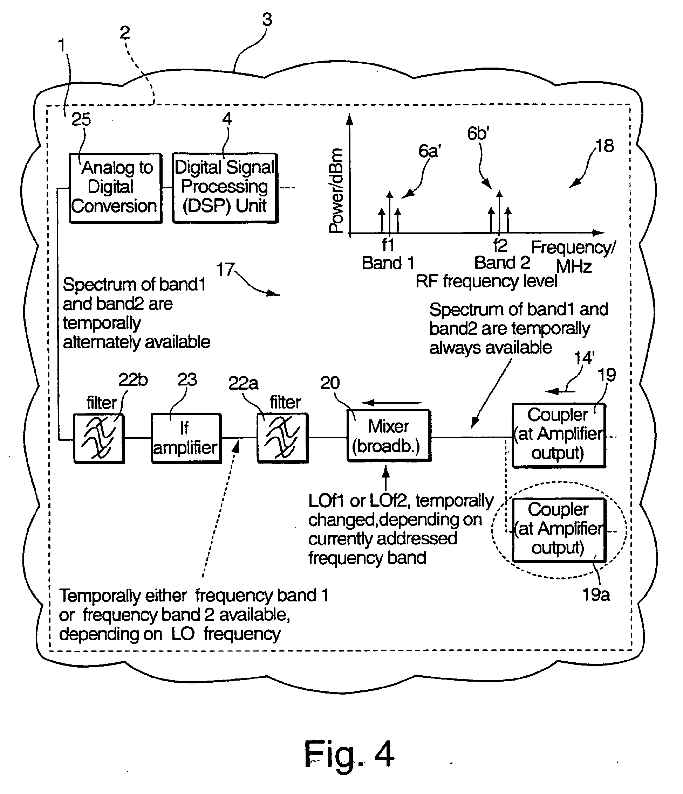

Another way of realizing a feedback path 17 without using parallel frequency paths is shown in **Fig. 4****.** The arrangement of Fig. 4 differs from the one shown in Fig. 3 mainly in that the frequency paths PF1, PF2 with the single-band mixers 20a, 20b are replaced by a single (broadband) mixer 20 having an adjustable local oscillator frequency. By temporally alternating the local oscillator frequency LOf1, LOf2 of the wideband mixer 20 in accordance with the fragmented frequency band 6a', 6b' to be currently provided to the digital signal unit 4 (after down-conversion), the same feedback hardware can be used in a time-shared manner in order to support fragmented spectrum applications. Thus, in the arrangement of Fig. 4, the use of a splitter / switch may be dispensed with.

One skilled in the art will readily appreciate that although Figs. 1 and 2 show exemplarily two frequency paths P1, P2 in the transmit path and two corresponding frequency paths PF1, PF2 in the feedback path 17, a higher number of frequency paths may also be chosen, depending on the number of frequency bands required in the desired application. It will be understood that when feedback for more than one amplifier is provided, the number of frequency paths in the feedback path may differ from the number of frequency paths in the forward/transmit path.

Either way, energy-efficient coverage of fragmented frequency bands can be supported by the proposed fragmented transmitter architecture without the need for later hardware modifications. In particular, when implementing the feedback architecture described above, the supportable bandwidth of the feedback path and of the linearization is increased, which e.g. supports highly efficient fragmented frequency band applications such as (future) Software Defined Radio or Cognitive Radio.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Also, the description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Transmitter arrangement (1) for amplifying a fragmented spectrum RF signal (14) having a plurality of frequency bands (6a', 6b') with different carrier frequencies (f1, f2), comprising:
a plurality of frequency paths (P1, P2), each for generating a single-band RF signal (12a, 12b) with a different RF carrier frequency (f1, f2),
a combiner (13) for generating the fragmented spectrum RF signal (14) by combining the plurality of single-band RF signals (12a, 12b), and
an amplifier unit (15) adapted for amplification of the fragmented spectrum RF signal (14),
**characterized by**
a feedback path (17) adapted for temporally alternately generating feedback for the different frequency bands (6a', 6b') of the amplified fragmented spectrum RF signal (14').

2. Transmitter arrangement according to claim 1, wherein each frequency path (P1, P2) comprises a mixer (11 a, 11 b) for generation of the single-band RF signal (12a, 12b) by mixing up a single-band baseband signal (5a, 5b) to the respective RF carrier frequency (f1, f2).

3. Transmitter arrangement according to claim 2, wherein each frequency path (P1, P2) comprises a filter (10a, 10b) for generating the single-band baseband signal (5a, 5b) by filtering a fragmented spectrum baseband input signal (5) having a plurality of frequency bands (6a, 6b) with different center frequencies (BBf1, BBf2).

4. Transmitter arrangement according to claim 3, further comprising a splitter (8) for distributing the fragmented spectrum baseband signal (5) to the different signal paths (P1, P2).

5. Transmitter arrangement according to claim 3 or 4, further comprising a digital signal processing unit (4) for generating the fragmented spectrum baseband signal (5).

6. Transmitter arrangement according to any one of the preceding claims, wherein the feedback path (17) is adapted for linearization of the amplification of the amplifier unit (15).

7. Transmitter arrangement according to claim 1, wherein the feedback path (17) comprises a plurality of frequency paths (PF1, PF2) for the different frequency bands (6a', 6b') of the fragmented spectrum RF signal (14), the feedback path (17) further comprising at least one switch (21, 24) for switching between the frequency paths (PF1, PF2).

8. Transmitter arrangement according to claim 7, wherein each frequency path (PF1, PF2) of the feedback path (17) comprises a filter (22a, 22b) for generating a feedback signal (18a, 18b) for one of the frequency bands (6a', 6b') of the fragmented spectrum RF signal (14).

9. Transmitter arrangement according to any one of claims 7 or 8, further comprising at least one mixer (20; 20a, 20b) for down-conversion of the fragmented spectrum RF signal (14), preferably to intermediate frequencies.

10. Transmitter arrangement according to claim 9, wherein the mixer (20) is adapted for switching its local oscillator frequency (LOf1, LOf2) in dependence of the frequency band (6a', 6b') of the amplified fragmented spectrum RF signal (14') for which the feedback is to be generated.

11. Base station (2) comprising at least one transmitter arrangement (1) according to any one of the preceding claims.

12. Radio network (3) comprising at least one transmitter arrangement (1) according to any one of claims 1 to 10.

13. Method for fragmented signal amplification, comprising:
generating a plurality of single-band RF signals (12a, 12b) at different RF carrier frequencies (f1, f2),
generating a fragmented spectrum RF signal (14) by combining the plurality of single-band RF signals (12a, 12b), and
amplifying the fragmented spectrum RF signal (14) using broadband amplification,
**characterized by**
performing linearization of the amplification of the fragmented spectrum RF signal (14) by using alternate feedback of the different frequency bands (6a', 6b') of the amplified fragmented spectrum RF signal (14').

14. Method according to claim 13, wherein the step of generating the single-band RF signals (12a, 12b) comprises mixing up single-band baseband signals (5a, 5b) to the respective RF carrier frequency (f1, f2), the single-band baseband signals (5a, 5b) being preferably generated by filtering a fragmented spectrum baseband signal (5) having a plurality of frequency bands (6a, 6b) with different center frequencies (BSf1, BSf2).

## Patentansprüche

1. Sendeanordnung (1) zur Verstärkung eines aufgespalteten RF-Spektrum-Signals (14), welches eine Mehrzahl von Frequenzbändern (6a', 6b') mit verschiedenen Frequenzträgern (f1, f2) aufweist, umfassend:
Eine Mehrzahl von Frequenzpfaden (P1, P2), von denen ein jeder für die Erzeugung eines Einzelband-RF-Signals (12a, 12b) mit einer verschiedenen RF-Trägerfrequenz (f1, f2) bestimmt ist,
einen Kombinator (13) zur Erzeugung des aufgespalteten RF-Spektrum-Signals (14) durch Kombinieren der Mehrzahl von Einzelband-RF-Signalen (12a, 12b), und
eine Verstärkereinheit (15), welche für die Verstärkung des aufgespalteten RF-Spektrum-Signals (14) ausgelegt ist,
**gekennzeichnet durch**
einen Rückkopplungspfad (17), geeignet für das zeitliche abwechselnde Erzeugen von Rückkopplung für die verschiedenen Frequenzbänder (6a', 6b') des verstärkten aufgespalteten RF-Spektrum-Signals (14').

2. Sendeanordnung nach Anspruch 1, wobei jeder Frequenzpfad (P1, P2) einen Mischer (11a, 11b) zum Erzeugen des Einzelband-RF-Signals (12a, 12b) durch Aufwärtsmischen eines Einzelband-Basisbandsignals (5a, 5b) in die entsprechende RF-Trägerfrequenz (f1, f2) umfasst.

3. Sendeanordnung nach Anspruch 2, wobei jeder Frequenzpfad (P1, P2) einen Filter (10a, 10b) für die Erzeugung des Einzelband-Basisbandsignals (5a, 5b) durch Filtern eines aufgespalteten Basisbandspektrum-Eingangssignals (5), welches eine Mehrzahl von Frequenzbändern (6a, 6b) mit verschiedenen Mittenfrequenzen (BBf1, BBf2) aufweist, umfasst.

4. Sendeanordnung nach Anspruch 3, weiterhin umfassend einen Splitter (8) für das Verteilen des aufgespalteten Basisbandspektrum-Signals (5) an die verschiedenen Signalpfade (P1, P2).

5. Sendeanordnung nach Anspruch 3 oder 4, weiterhin umfassend eine digitale Signalverarbeitungseinheit (4) für die Erzeugung des aufgespalteten Basisbandspektrum-Signals (5).

6. Sendeanordnung nach einem beliebigen der vorstehenden Ansprüche, wobei der Rückkopplungspfad (17) für die Linearisierung der Verstärkung der Verstärkereinheit (15) geeignet ist.

7. Sendeanordnung nach Anspruch 1, wobei der Rückkopplungspfad (17) eine Mehrzahl von Frequenzpfaden (PF1, PF2) für die verschiedenen Frequenzbänder (6a', 6b') des aufgespalteten RF-Spektrum-Signals (14) umfasst, wobei der Rückkopplungspfad (17) weiterhin mindestens einen Switch (21, 24) zum Umschalten zwischen den Frequenzpfaden (PF 1, PF2) umfasst.

8. Sendeanordnung nach Anspruch 7, wobei jeder Frequenzpfad (PF1, PF2) des Rückkopplungspfads (17) einen Filter (22a, 22b) für die Erzeugung eines Rückkopplungssignals (18a, 18b) für eines der Frequenzbänder (6a', 6b') des aufgespalteten RF-Spektrum-Signals (14) umfasst.

9. Sendeanordnung nach einem beliebigen der Ansprüche 7 oder 8, weiterhin umfassend mindestens einen Mischer (20; 20a, 20b) für die Abwärtskonversion des aufgespalteten RF-Spektrum-Signals (14), vorzugsweise in Zwischenfrequenzen.

10. Sendeanordnung nach Anspruch 9, wobei der Mischer (20) für das Schalten seiner Lokaloszillatorfrequenz (L0f1, L0f2) in Abhängigkeit von dem Frequenzband (6a', 6b') des verstärkten aufgespalteten RF-Spektrum-Signals (14'), für welches die Rückkopplung zu erzeugen ist, geeignet ist.

11. Basisstation (2) mit mindestens einer Sendeanordnung (1) gemäß einem beliebigen der vorstehenden Ansprüche.

12. Funknetzwerk (3) mit mindestens einer Sendeanordnung (1) gemäß einem beliebigen der Ansprüche 1 bis 10.

13. Verfahren zur Verstärkung von aufgespalteten Signalen, umfassend:
Erzeugen einer Mehrzahl von Einzelband-RF-Signalen (12a, 12b) mit verschiedenen RF-Trägerfrequenzen (f1, f2),
Erzeugen eines aufgespalteten RF-Spektrum-Signals (14) durch Kombinieren der Mehrzahl von Einzelband-RF-Signalen (12a, 12b), und
Verstärken des aufgespalteten RF-Spektrum-Signals (14) unter Verwendung von Breitbandverstärkung,
**gekennzeichnet durch**
Durchführen einer Linearisierung der Verstärkung des aufgespalteten RF-Spektrum-Signals (14) **durch** Verwenden einer alternativen Rückkopplung der verschiedenen Frequenzbänder (6a', 6b') des verstärkten aufgespalteten RF-Spektrum-Signals (14').

14. Verfahren nach Anspruch 13, wobei der Schritt des Erzeugens des Einzelband-RF-Signals (12a, 12b) das Aufwärtsmischen von Einzelband-Basisbandsignalen (5a, 5b) in die entsprechende RF-Trägerfrequenz (f1, f2) umfasst, wobei die Einzelband-Basisbandsignale (5a, 5b) vorzugsweise durch das Filtern eines aufgespalteten Basisbandspektrum-Signals (5), welches eine Mehrzahl von Frequenzbändern (6a, 6b) mit verschiedenen Mittenfrequenzen (BSf1, BSf2) aufweist, erzeugt werden.

## Revendications

1. Dispositif émetteur (1) pour amplifier un signal RF à spectre fragmenté (14) présentant une pluralité de bandes de fréquences (6a', 6b') avec des fréquences porteuses (f1, f2) différentes, comprenant :
une pluralité de trajets de fréquence (P1, P2), chacun pour générer un signal RF à bande unique (12a, 12b) avec une fréquence porteuse RF (f1, f2) différente, un combineur (13) pour générer le signal RF à spectre fragmenté (14) en combinant la pluralité de signaux RF à bande unique (12a, 12b), et une unité d'amplification (15) adaptée pour l'amplification du signal RF à spectre fragmenté (14),
**caractérisé par** les étapes suivantes
un trajet de contre-réaction (17) adapté pour générer en alternance et temporellement une contre-réaction pour les bandes de fréquences (6a', 6b') différentes du signal RF à spectre fragmenté amplifié (14').

2. Dispositif émetteur selon la revendication 1, dans lequel chaque trajet de fréquence (P1, P2) comprend un mélangeur (11a, 11b) pour la génération du signal RF à bande unique (12a, 12b) en mélangeant un signal en bande de base à bande unique (5a, 5b) avec la fréquence porteuse RF (f1, f2) respective.

3. Dispositif émetteur selon la revendication 2, dans lequel chaque trajet de fréquence (P1, P2) comprend un filtre (10a, 10b) pour générer le signal en bande de base à bande unique (5a, 5b) en filtrant un signal d'entrée en bande de base à spectre fragmenté (5) présentant une pluralité de bandes de fréquences (6a, 6b) avec des fréquences centrales (BBf1, BBf2) différentes.

4. Dispositif émetteur selon la revendication 3, comprenant en outre un répartiteur (8) pour distribuer le signal en bande de base à spectre fragmenté (5) aux trajets de signaux (P1, P2) différents.

5. Dispositif émetteur selon la revendication 3 ou 4, comprenant en outre une unité de traitement de signal numérique (4) pour générer le signal en bande de base à spectre fragmenté (5).

6. Dispositif émetteur selon l'une quelconque des revendications précédentes, dans lequel le trajet de contre-réaction (17) est adapté pour la linéarisation de l'amplification de l'unité d'amplification (15).

7. Dispositif émetteur selon la revendication 1, dans lequel le trajet de contre-réaction (17) comprend une pluralité de trajets de fréquence (PF1, PF2) pour les bandes de fréquences (6a', 6b') différentes du signal RF à spectre fragmenté (14), le trajet de contre-réaction (17) comprenant en outre au moins un commutateur (21, 24) pour la commutation entre les trajets de fréquence (PF1 , PF2).

8. Dispositif émetteur selon la revendication 7, dans lequel chaque trajet de fréquence (PF1, PF2) du trajet de contre-réaction (17) comprend un filtre (22a, 22b) pour générer un signal de contre-réaction (18a, 18b) pour une des bandes de fréquences (6a', 6b') du signal RF à spectre fragmenté (14).

9. Dispositif émetteur selon l'une quelconque des revendications 7 ou 8, comprenant en outre au moins un mélangeur (20 ; 20a, 20b) pour la conversion descendante du signal RF à spectre fragmenté (14), de préférence à des fréquences intermédiaires.

10. Dispositif émetteur selon la revendication 9, dans lequel le mélangeur (20) est adapté pour effectuer la commutation de sa fréquence d'oscillateur local (LOf1, LOf2) en fonction de la bande de fréquences (6a', 6b') du signal RF à spectre fragmenté amplifié (14') pour laquelle la contre-réaction doit être générée.

11. Station de base (2) comprenant au moins un dispositif émetteur (1) selon l'une quelconque des revendications précédentes.

12. Réseau radio (3) comprenant au moins un dispositif émetteur (1) selon l'une quelconque des revendications 1 à 10.

13. Procédé pour l'amplification d'un signal fragmenté, comprenant les étapes suivantes :
générer une pluralité de signaux RF à bande unique (12a, 12b) à fréquences porteuses RF (f1, f2) différentes,
générer un signal RF à spectre fragmenté (14) en combinant la pluralité de signaux RF à bande unique (12a, 12b), et
amplifier le signal RF à spectre fragmenté (14) en utilisant une amplification à large bande,
**caractérisé par** l'étape suivante
effectuer une linéarisation de l'amplification du signal RF à spectre fragmenté (14) en utilisant une contre-réaction alternée des bandes de fréquences (6a', 6b') différentes du signal RF à spectre fragmenté amplifié (14').

14. Procédé selon la revendication 13, dans lequel l'étape de génération de signaux RF à bande unique (12a, 12b) comprend le mélange de signaux en bande de base à bande unique (5a, 5b) avec la fréquence porteuse RF (f1, f2) respective, les signaux en bande de base à bande unique (5a, 5b) étant de préférence générés en filtrant un signal en bande de base à spectre fragmenté (5) présentant une pluralité de bandes de fréquences (6a, 6b) avec des fréquences centrales (BSf1, BSf2) différentes.
